# EUROPEAN PATENT APPLICATION

(11) **EP 1 475 827 A1**
(43) Date of publication of application: **10.11.2004**
(21) Application number: 03791287.0
(22) Date of filing: 26.08.2003
(51) Int. Cl.: H01L 21/304

(54) **POLISHING PAD, POLISHING PLATE HOLE COVER, POLISHING APPARATUS, POLISHING METHOD, AND METHOD FOR MANUFACTURING SEMICONDUCTOR DEVICE**

(30) Priority: 30.08.2002 JP 2002253711
(71) Applicant: TORAY INDUSTRIES, INC., Tokyo 103-8666 (JP)
(72) Inventor: SHIRO, Kuniyasu, Koka-gun, Shiga 520-3221 (JP); KOBAYASHI, Tsutomu, Otsu-shi, Shiga 520-0842 (JP); HASHISAKA, Kazuhiko, Otsu-shi, Shiga 520-2133 (JP)
(74) Representative: Kador & Partner
(86) International application number: PCT/JP2003/010749
(87) International publication number: WO 2004/021426

(57) **Abstract**

It is an object of the present invention to provide a windowed polishing pad or a platen hole cover which is used to form planar surfaces in glass, semiconductors, dielectric/metal composites, integrated circuits, etc.; a polishing apparatus including the windowed polishing pad or the platen hole cover; a method for fabricating a semiconductor device using the polishing apparatus; and a polishing method, in which the number of scratches occurring on the surface of the substrate is small, and the polished state can be optically measured satisfactorily during polishing.

In order to achieve the above object, a polishing pad is constructed in such a manner that the polishing pad includes a polishing layer and a light-transmissive window member disposed in an opening formed in a part of the polishing layer, wherein the amount of indentation strain measured when a constant load is applied to substantially the entire upper surface of the light-transmissive window member is larger than the amount of indentation strain measured when the same constant load is applied to a region having the same area on the upper surface of the polishing layer.

## Description

### Technical Field

The present invention relates to a windowed polishing pad which is suitable for use to form planar surfaces in semiconductors, dielectric/metal composites, integrated circuits, etc.; a platen hole cover; a polishing apparatus including the windowed polishing pad or the platen hole cover; and a method for fabricating a semiconductor device using the polishing apparatus.

### Background Art

As the density of semiconductor devices is increasing, multilevel interconnections and techniques associated therewith, for example, techniques for forming interlayer insulating films and techniques for forming electrodes using plug processes, damascene processes, or the like are becoming important. Accordingly, planarization processes for such interlayer insulating films and metal films of electrodes are also becoming important. As an efficient technique for the planarization processes, a polishing technique referred to as chemical mechanical polishing (CMP) is widely used. As disclosed in Japanese Unexamined Patent Application Publication No. 9-7985, a polishing apparatus using CMP is receiving attention as an important technique in which, while a substrate, such as a wafer, is being polished, a laser beam or visible light is applied from the back side (platen side) of the polishing pad to a surface of the substrate to be polished so that the polished state is measured. As the polishing pad used for such a polishing apparatus, PCT Japanese Translation Patent Publication No. 11-512977 discloses a polishing pad useful for the polishing of wafers provided with integrated circuits, at least a portion of the pad being composed of a solid uniform resin sheet with no intrinsic ability to absorb or transport slurry particles, the resin sheet being transparent to light having a wavelength within the range of 190 to 3,500 nanometers. The polishing pad includes a polishing layer and a cushion layer laminated on the polishing layer with a double-sided adhesive tape or the like therebetween. An opening is formed at a predetermined position of the polishing pad, and a window member composed of a transparent solid uniform resin is fitted in the opening. The window member transmits light so that the surface to be polished can be observed, and prevents polishing slurry from entering the platen hole and getting behind the back of the platen. However, in the polishing pad using such a transparent solid uniform resin for the window member, since the window member comes into contact with the surface of the substrate, i.e., the surface to be polished, scratches easily occur on the surface of the substrate, which is problematic. Moreover, since the window member does not uniformly come into contact with the surface of the substrate, i.e., the surface to be polished, the slurry is interposed between the window member and the surface of the substrate. As a result, light reflected at the surface of the substrate is scattered, and it is not possible to achieve satisfactory measurement accuracy, which is also problematic.

### Disclosure of Invention

It is an object of the present invention to provide a windowed polishing pad or a platen hole cover which is used to form planar surfaces in glass, semiconductors, dielectric/metal composites, integrated circuits, etc.; a polishing apparatus including the windowed polishing pad or the platen hole cover; a method for fabricating a semiconductor device using the polishing apparatus; and a polishing method, in which the number of scratches occurring on the surface of the substrate is small, and the polished state can be optically measured satisfactorily during polishing.

In order to achieve this object, the present invention has the constructions described below.
(1) A polishing pad includes a polishing layer and a light-transmissive window member disposed in an opening formed in a part of the polishing layer, wherein the amount of indentation strain (S1) measured under a load W applied to the light-transmissive window member having an upper area A is larger than the amount of indentation strain (S2) measured under a load W applied to a region having the area A at any position on the upper surface of the polishing layer.
(2) In the polishing pad according to (1), S1/S2 ≥ 1.5.
(3) In the polishing pad according to either (1) or (2), the light-transmissive window member is supported by a highly deformable member.
(4) In the polishing pad according to (3), the compression modulus of the highly deformable member is 0.001 to 0.8 MPa.
(5) In the polishing pad according to any one of (1) to (4), at least a part of the light-transmissive window member is disposed at a position higher than the surface of the polishing layer.
(6) In the polishing pad according to any one of (1) to (5), the light-transmissive window member has a region having a micro rubber A-type hardness of 60 degrees or less and a region having a rubber microhardness of 80 degrees or more.
(7) In the polishing pad according to any one of (1) to (6), the light-transmissive window member has a phase separation structure.
(8) A polishing apparatus includes at least the polishing pad according to any one of (1) to (7), means for supplying an abrasive material between the polishing pad and a workpiece, means for making the polishing pad abut on the workpiece and relatively moving the polishing pad and the workpiece to perform polishing, and means for optically measuring the polished state of the workpiece through the light-transmissive window member.
(9) A method for fabricating a semiconductor device includes the step of polishing a surface of a semiconductor substrate using the polishing apparatus according to (8).
(10) A platen hole cover includes a light-transmissive window member, the platen hole cover being used together with a polishing pad having an opening and fixed on a hole of a platen in a polishing apparatus in which the polished state can be optically measured, wherein the amount of indentation strain (S'1) measured under a load W' applied to the upper surface of the light-transmissive window member having an upper area A' is larger than the amount of indentation strain (S'2) measured under a load W' applied to a region having the area A' at any position on the upper surface of a polishing layer of the polishing pad used together.
(11) In the platen hole cover according to (10), S'1 ≥ S'2.
(12) In the platen hole cover according to either (10) or (11), the light-transmissive window member is supported by a highly deformable member.
(13) In the platen hole cover according to (12), the compression modulus of the highly deformable member is 0.001 to 0.8 MPa.
(14) In the platen hole cover according to any one of (10) to (13), at least a part of the upper surface of the light-transmissive window member is disposed at a position higher than the surface of the polishing layer of the polishing pad before the start of polishing.
(15) In the platen hole cover according to any one of (10) to (14), the light-transmissive window member has a region having a micro rubber A-type hardness of 60 degrees or less and a region having a micro rubber A-type hardness of 80 degrees or more.
(16) In the platen hole cover according to any one of (10) to (15), the light-transmissive window member has a phase separation structure.
(17) A polishing apparatus includes the platen hole cover according to any one of (10) to (16), a polishing pad having an opening engageable with the platen hole cover, means for supplying an abrasive material between the polishing pad and a surface to be polished, means for making the polishing pad abut on the surface to be polished and relatively moving the polishing pad and the surface to be polished to perform polishing, and means for optically measuring the polished state of a workpiece through the light-transmissive window member.
(18) A method for fabricating a semiconductor device includes the step of polishing a surface of a semiconductor substrate using the polishing apparatus according to (17).
(19) A method for polishing a workpiece includes the steps of disposing a polishing pad including a polishing layer, a light-transmissive window member which constitutes a part of the polishing pad or which is independent of the polishing pad on a platen so that the polishing pad and the light-transmissive window member can abut against the workpiece; setting the amount of indentation strain (S"1) measured under a load W" applied to the upper surface of the light-transmissive window member having an upper area A" to be larger than the amount of indentation strain (S"2) measured under a load W" is applied to a region having the area A" at any position on the surface of the polishing layer of the polishing pad; and supplying an abrasive material between the polishing pad and the workpiece while the polished state of the workpiece is being optically measured through the light-transmissive window member.

In accordance with the present invention, it is possible to provide a windowed polishing pad or a platen hole cover which is used to form planar surfaces in glass, semiconductors, dielectric/metal composites, integrated circuits, etc.; a polishing apparatus including the windowed polishing pad or the platen hole cover; a method for fabricating a semiconductor device using the polishing apparatus; and a polishing method, in which the number of scratches occurring on the surface of the substrate is small, and the polished state can be optically measured satisfactorily through the windowed polishing pad or the platen hole cover during polishing.

### Brief Description of the Drawings

Fig. 1 is a plan view which shows a polishing pad including a light-transmissive window member.
Fig. 2 is a cross-sectional view which shows an example of a structure of a polishing pad including a light-transmissive window member of the present invention.
Fig. 3 is a cross-sectional view which shows another example of a structure of a polishing pad including a light-transmissive window member of the present invention.
Fig. 4 is a cross-sectional view which shows another example of a structure of a polishing pad including a light-transmissive window member of the present invention.
Fig. 5 is a cross-sectional view which shows another example of a structure of a polishing pad including a light-transmissive window member of the present invention.
Fig. 6 is a cross-sectional view which shows an example of a platen hole cover of the present invention.
Fig. 7 is a side view which shows an embodiment of a polishing apparatus which is capable of optically measuring the polished state.
Fig. 8 is a side view which shows another embodiment of a polishing apparatus which is capable of optically measuring the polished state.

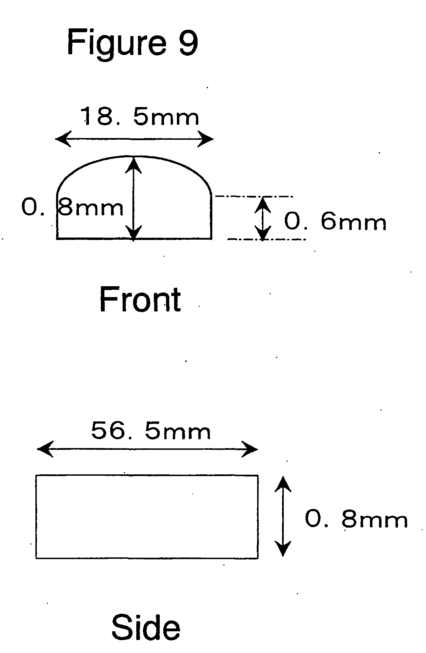

Fig. 9 shows an example of a shape of a light-transmissive window member of the present invention.

### Reference Numerals

- 1: polishing layer
- 2: light-transmissive window member
- 3: polishing pad
- 4: adhesion layer
- 5: cushion layer
- 6: flexible light-transmissive layer in light-transmissive window member
- 7: highly deformable member
- 8: adhesion layer
- 9: workpiece
- 10: polishing head
- 11: hole
- 12: beam splitter
- 13: light source
- 14: photodetector
- 15: incident light
- 16: reflected light
- 17: platen
- 18: platen hole cover

### Best Mode for Carrying Out the Invention

Examples of polishing pads of the present invention include a structure including a polishing layer and an adhesion member, and a layered structure including a polishing layer, a cushion layer, and an adhesion member.

Any polishing layer which is capable of polishing a workpiece and holding a slurry during polishing may be used. Examples include polishing layers having rigid foamed structures including closed cells, such as the ones disclosed in PCT Japanese Translation Patent Publication No. 8-500622 and PCT Publication No. 00/12262 pamphlet; a polishing layer having an unfoamed structure including small channels provided on the surface which permit the transport of slurry, as disclosed in PCT Japanese Translation Patent Publication No. 8-511210; and polishing layers having foamed structures including open cells prepared by impregnating nonwoven fabrics with polyurethanes.

The light-transmissive window member constituting a part of the polishing pad is fitted in an opening formed in a part of the polishing surface and constructed so that light can be transmitted from the front surface to the back surface of the polishing pad. The light-transmissive window member is sufficiently transparent to_optical wavelengths in order to observe and measure the surface of the workpiece with a haze value of 90% or less, preferably 70% or less, or more preferably 50% or less. The light-transmissive window member used for the platen hole cover of the present invention is fixed so as to cover an opening of a platen in a polishing apparatus in which the polished state can be optically measured, and has a haze value of 90% or less, preferably 70% or less, and more preferably 50% or less. That is, the light-transmissive window member is defined as a member which has a haze value of 90% or less, preferably 70% or less, and more preferably 50% or less. Although the lower limit of the haze value is not particularly set, light-transmissive window members with a haze value of about 0.01% or more are usually advantageous in view of the possibility of industrial production.

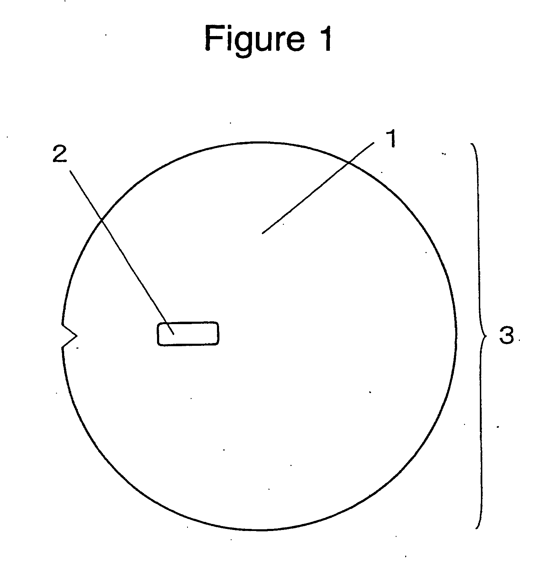

Herein, the haze value is defined by the following equation: Haze value (%) = (diffuse transmittance/total transmittance) × 100. As the haze value is decreased, the amount of transmitted light is increased, and the amount of radiation of light to the substrate is increased, which is desirable. The opening in the polishing layer preferably has a slightly larger area than that of the light-transmissive window member so that the light-transmissive window member can be fitted into the opening. Fig. 1 shows an example of a structure of a windowed polishing pad of the present invention which includes a polishing layer and a light-transmissive window member fitted in an opening formed in a part of the polishing layer in order to optically measure the polished state.

In the windowed polishing pad including the light-transmissive window member of the present invention, the amount of indentation strain (S1) measured when a load W is applied to the light-transmissive window member having an upper area A is larger than the amount of indentation strain (S2) measured when a load W is applied to a region having the area A at any position on the upper surface of the polishing layer. Herein, the upper area corresponds to the apparent area of the exposed light-transmissive window member in the polishing layer. That is, the upper area corresponds to the projected area of the exposed region when viewed from the top although the upper surface of the light-transmissive window member may have various shapes, such as a planar shape and a curved shape. Additionally, even if the light-transmissive window is partially or entirely covered with a film of another material, such as a constituent of the polishing layer, the light-transmissive window should be considered as being substantially exposed. The reason for this is that the film does not substantially affect the amount of indentation strain when the load is applied.

Since the load W must be uniformly applied to the region to be pressed, ideally, a constant pressure is applied to substantially the entire surface of the region to be pressed. However, when the light-transmissive window member has sufficient rigidity, even if a constant pressure is not necessarily applied to the entire surface, self-evidently, the same effect is achieved as that yielded from the case when a constant pressure is applied to the entire surface. When the load is applied, any appropriate method may be used. For example, a jig including a region with the area A which is brought into contact with the polishing layer or the light-transmissive window member may be used.

When the amount of indentation strain on the upper surface of the polishing layer is measured, the region which is affected by the light-transmissive window member should not be selected arbitrarily. Although the amount of indentation strain can be measured at any position, it is proper to calculate the average of the values measured at any ten positions or the like as a representative physical property of the entire polishing layer.

In order to ideally measure the amount of indentation strain at the light-transmissive window member, using an indenter which has substantially the same shape as that of the upper surface of the light-transmissive window member, an area of at least 80% of the upper area of the light-transmissive window member, and a substantially similar shape as that of the light-transmissive window member, a constant pressure is applied while the indenter is brought into contact with substantially the entire upper surface of the light-transmissive window member so as not to be in contact with the polishing layer. In order to ideally measure the amount of indentation strain at the surface of the polishing layer, using the same apparatus used for measuring the amount of indentation strain at the light-transmissive window member and the same indenter, the same constant pressure is applied. However, if the indenter used for pressing the light-transmissive window member is not flat, a flat indenter is used for the polishing layer.

As the method for measuring the amount of indentation strain, a universal material testing machine which is commonly used to measure compression strain, such as a Universal Testing Machine Model 1185 or Model 5565 manufactured by Instron Corporation, may be used. The load W is selected from the range of 100 g to 8,000 g, and usually, a load which generates a pressure of 0.005 to 0.15 MPa is selected. Such a range corresponds to the range of the pressure applied from the surface to be polished to the upper surface of the light-transmissive window member or the upper surface of the polishing layer during actual polishing. By selecting the pressure from the same range when the amount of indentation strain is measured, a suitable polishing pad is obtained under the actual polishing conditions. The testing rate is set at 0.1 mm/min.

The amount of indentation strain is defined as the difference between the strain generated when 10% of a constant load (pressure) is applied and the strain generated when the constant pressure is applied.

Briefly speaking, the present invention is characterized in that when the same pressure is applied to the upper surface of the light-transmissive window member and the upper surface of the polishing layer, the amount of indentation strain of the light-transmissive window member is larger than that of the polishing layer. In such a construction, even if an excessive pressure occurs locally, it is possible to prevent scratches from occurring on the surface of the workpiece because the light-transmissive window member is easily indented.

The amount of indentation strain (S1) at the upper surface of the light-transmissive window member is preferably 1.2 times or more, more preferably 1.5 times or more, still more preferably 2.0 times or more, or most preferably 2.5 times or more the amount of indentation strain (S2) at the upper surface of the polishing layer. As the difference between the amount of indentation strain of the light-transmissive window member and the amount of indentation strain of the polishing layer is increased, it is possible to decrease the number of scratches occurring on the surface of the workpiece. Examples of specific structures of the polishing pad which is constructed so that the amount of indentation strain at the upper surface of the light-transmissive window member is larger than the amount of indentation strain at the upper surface of the polishing layer are described below.

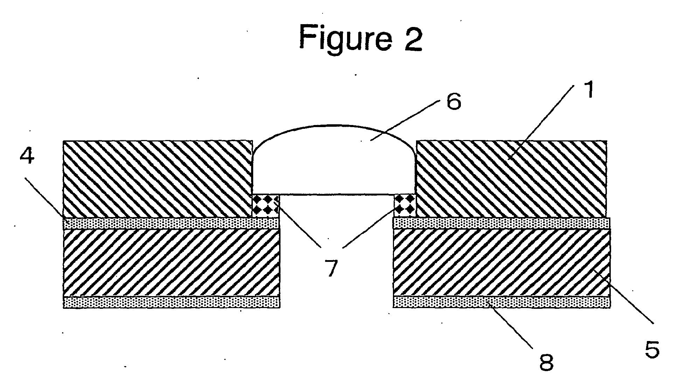

Fig. 2 shows an example of a structure which includes a double-layer polishing pad including a cushion layer and a polishing layer. A light-transmissive window member is provided on the polishing pad. The light-transmissive window member is supported by a highly deformable member disposed on the cushion layer. In this structure, since the highly deformable member is easily deformed in response to the indentation force, it is possible to set the amount of indentation strain of the light-transmissive window member to be larger than the amount of indentation strain of the polishing layer.

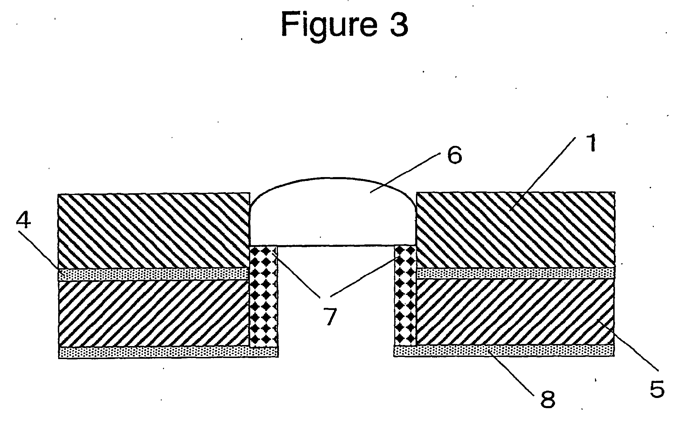

Fig. 3 shows an example of a structure which includes a double-layer polishing pad including a cushion layer and a polishing layer. A light-transmissive window member is provided on the polishing pad. The light-transmissive window member is supported by a highly deformable member disposed on an adhesive layer disposed on the bottom. Since the thickness of the highly deformable member is larger than that of the highly deformable member shown in Fig. 2, it is possible to set the amount of indentation strain of the light-transmissive window member to be much larger than the amount of indentation strain of the polishing layer.

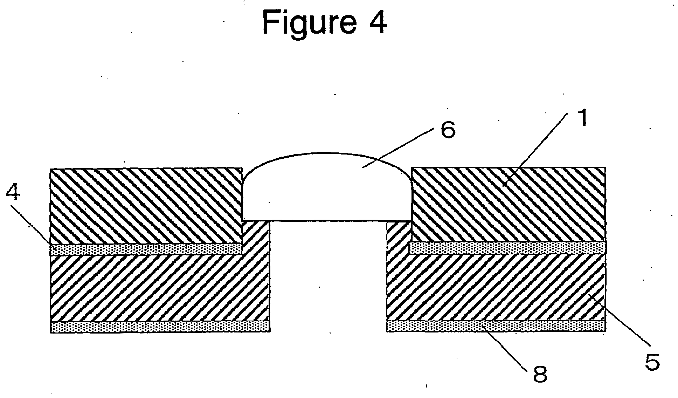

Fig. 4 shows an example of a structure which includes a double-layer polishing pad including a cushion layer and a polishing layer. A light-transmissive window member is provided on the polishing pad. The thickness of the cushion layer at the portion supporting the light-transmissive window member is larger than the thickness of the cushion layer at the portion supporting the polishing layer. In this structure, it is possible to set the amount of indentation strain of the light-transmissive window member to be larger than the amount of indentation strain of the polishing layer.

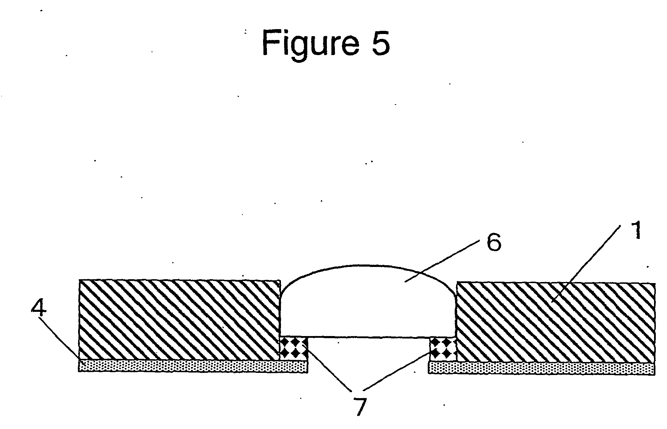

Fig. 5 shows an example of a structure which includes a single-layer polishing pad. A light-transmissive window member is provided on the polishing pad. The light-transmissive window member is supported by a highly deformable member disposed on an adhesive layer disposed at the bottom. It is possible to set the amount of indentation strain of the light-transmissive window member to be larger than the amount of indentation strain of the polishing layer.

The highly deformable member is defined as a member which is more easily deformed compared with the polishing layer or the cushion layer. Being easily deformed means having a large deformation in the same shape (in which additive properties, linearity, etc., may also be considered, if necessary) under the same compressive stress (pressure). As such a member, a foamed sheet is preferably used because of its large deformation and high deformation recovery. Preferably, a highly deformable member having a compression modulus of 0.001 to 0.8 MPa is used. By using such a highly deformable member, the pressure temporarily applied to the light-transmissive window member can be efficiently absorbed. Therefore, scratches can be substantially prevented from occurring on the surface of the workpiece. Since the highly deformable member must be firmly bonded to the light-transmissive window member, a foam-type adhesive tape in which a foamed sheet is used as a base and adhesion layers are provided on both sides of the base is preferably used. Specific examples thereof include acrylic foam structural adhesive tapes Y-4950, Y-4930, Y-4920, Y-4914, Y-4627, Y-4630F, Y-4609, Y-4615, Y-4604, Y-4608, Y-4612, Y-4620, etc., manufactured by Sumitomo 3M Ltd., and double-sided tapes 7840 (0.4 white), 7840 (0.6 white), 782 (0.8), etc., manufactured by Teraoka Seisakusho Co., Ltd. The foamed sheet is preferably composed of closed cells because it must prevent the entry of polishing slurry. Preferred examples of such a foamed sheet include EPT sponge manufactured by Daiwabo Co., Ltd., such as EPT#120, EPT#140, EPT#300, EPT#310, EPT#320, and EPT#450.

The thickness and shape of the highly deformable member may be adjusted appropriately depending on the hardness and deformability of the polishing layer, the cushion layer, or the light-transmissive window member.

The platen hole cover of the present invention includes a light-transmissive window member fixed on a hole of a platen in a polishing apparatus in which the polished state can be optically measured; a member for supporting the light-transmissive window member; and means for fixing the light-transmissive window member on the platen. The platen hole cover is a member which covers the entire surface of the hole opened in the platen so that light can be transmitted, which is used together with a polishing pad having an opening, which prevents the entry of polishing slurry, and which transmits measuring light. The platen hole cover of the present invention is characterized in that the amount of indentation strain (S'1) measured when a load W' is applied to the light-transmissive window member having an upper area A' is larger than the amount of indentation strain (S'2) measured when a load W' is applied to a region having the area A' at any position on the upper surface of the polishing layer of the polishing pad used together.

Herein, the upper area A' of the light-transmissive window member is defined as in the upper area A in the polishing pad of the present invention described above. The upper area corresponds to the apparent area of the light-transmissive window member when viewed from the top. That is, the upper area corresponds to the projected area when viewed from the top.

The load W', application of the load, measurement of the amounts of indentation strain (S'1, S'2), and other preferred constructions can be considered as in the polishing pad described above.

In the present invention, the amount of indentation strain at the upper surface of the light-transmissive window member of the platen hole cover is larger than the amount of indentation strain at the upper surface of the polishing layer. In such a construction, even if an excessive pressure occurs locally, it is possible to prevent scratches from occurring on the surface of the workpiece because the light-transmissive window member is easily indented.

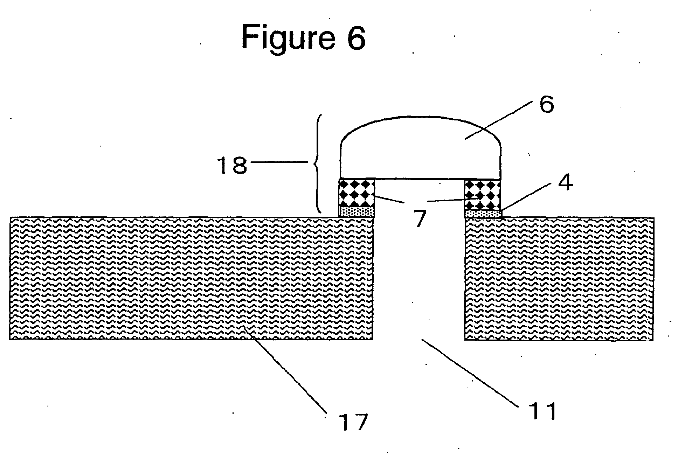

Specific examples will now be described below. The load applied to the platen hole cover including the light-transmissive window member is preferably in the range of 100 to 8,000 g. Such a range corresponds to the range of the constant load applied from the surface to be polished to the upper surface of the light-transmissive window member or the upper surface of the polishing layer during actual polishing. By selecting the constant load from the same range when the amount of indentation strain is measured, a suitable platen hole cover is obtained under the actual polishing conditions, which is desirable. In the platen hole cover of the present invention, under the constant load selected from the range of 100 to 8,000 g, the amount of indentation strain at the upper surface of the light-transmissive window member is preferably 1.5 times or more, more preferably 2.0 times or more, or most preferably 2.5 times or more the amount of indentation strain at the upper surface of the polishing layer. As the difference between the amount of indentation strain at the upper surface of the light-transmissive window member of the platen hole cover and the amount of indentation strain at the upper surface of the polishing layer is increased, it is possible to decrease the number of scratches occurring on the surface to be polished. Fig. 6 shows a specific example of the structure of the platen hole cover in which the amount of indentation strain at the upper surface of the light-transmissive window member is larger than the amount of indentation strain at the upper surface of the polishing layer. In this structure, the light-transmissive window is supported by a highly deformable member. The highly deformable member has a hole in the center and can be bonded to the platen so as to cover the platen hole, thereby preventing a polishing slurry from entering the platen hole. The platen hole cover can be bonded to the platen independently of the polishing pad. When the polishing pad is replaced at the end of its life, if the platen hole cover is not damaged, the platen hole cover can be used continuously, which is advantageous. As the highly deformable member, the same materials described above may be used.

The light-transmissive window member will be described in more detail below. The light-transmissive window member of the windowed polishing pad and the light-transmissive window member of the platen hole cover can be composed of the same material and can have the same characteristics.

The light-transmissive window member used in the present invention preferably has a region having a micro rubber A-type hardness of 60 degrees or less (also referred to as flexible light-transmissive layer) and a region having a micro rubber A-type hardness of 80 degrees or more (also referred to as rigid light-transmissive layer) in view of the fact that scratches can be more successfully prevented from occurring and that, since a slurry is not interposed between the surface of the light-transmissive window member and the surface to be polished during polishing, the polished state can be optically measured satisfactorily. The flexible light-transmissive layer is preferably provided in the outermost region of the polishing layer, i.e., in the outermost region on the surface to be polished. The flexible light-transmissive layer and the rigid light-transmissive layer may be laminated on each other. Alternatively, a structure whose hardness gradually changes or a structure in which domains of individual regions are distributed may be acceptable.

Herein, the micro rubber A-type hardness will be described. This hardness is defined as a value measured with a rubber microhardness durometer MD-1 manufactured by Kobunshi Keiki Co., Ltd. The rubber microhardness durometer MD-1 can measure the hardness of thin/small specimens that are difficult to measure with conventional hardness durometers. The rubber microhardness durometer MD-1 is designed and manufactured as a model reduced to about 1/5 of a spring-system rubber hardness durometer A. The value measured with the rubber microhardness durometer MD-1 corresponds to the hardness measured with the spring-system rubber hardness durometer A. The rubber microhardness durometer MD-1 includes a cylindrical indenter point with a diameter of 0.16 mm and a height of 0.5 mm. Loading is performed with a cantilever leaf spring, and the spring load is 2.24 mN at 0 point and 33.85 mN at 100 point. The indenter point is controlled with a stepping motor at a descending rate of 10 to 30 mm/sec to perform measurement. Each of the flexible light-transmissive layer and the rigid light-transmissive layer has a thickness of less than 5 mm, which is too thin to be evaluated with the spring-system rubber hardness durometer A. Therefore, the rubber microhardness durometer MD-1 is used for evaluation.

The micro rubber A-type hardness of the flexible light-transmissive layer is preferably 50 degrees or less and more preferably 40 degrees or less. Although the lower limit is not particularly set, a flexible light-transmissive layer with a micro rubber A-type hardness of about 10 degrees or more is preferably used from a practical standpoint. When the flexible light-transmissive layer is brought into contact with a substrate, it is deformed at the surface of the substrate because of its softness, and a wide region of the flexible light-transmissive layer is in contact with the surface of the substrate. The slurry interposed between the flexible light-transmissive layer and the substrate is easily discharged from the contact area, and measuring light is not easily scattered by the slurry. Consequently, the polished state can be measured satisfactorily. Since the flexible light-transmissive layer is soft, scratches can be prevented from occurring on the surface of the substrate.

By combining the flexible light-transmissive layer with the rigid light-transmissive layer, when the flexible light-transmissive layer is brought into contact with the substrate, the back of the flexible light-transmissive layer is supported by the rigid light-transmissive layer, and the surface of the light-transmissive window member is easily pressed against the surface of the substrate. The surface of the flexible light-transmissive layer is deformed, and a wider region of the flexible light-transmissive layer is in contact with the surface of the substrate. The slurry interposed between the flexible light-transmissive layer and the substrate is easily discharged from the contact area, and scattering of light does not easily occur. Consequently, measurement can be performed more satisfactorily.

Specific examples of materials for the flexible light-transmissive layer include transparent rubbers and transparent gels. By using such materials, the surface of the flexible light-transmissive layer is very rapidly deformed when it is in contact with the substrate, and thereby the slurry is discharged efficiently, which is desirable. Specific examples of transparent rubbers include silicone rubbers and flexible polyurethane rubbers. A silicone rubber is prepared by reacting a polydimethylsiloxane main chain with a silane crosslinking agent or the like. It is possible to freely control the micro rubber A-type hardness depending on the molecular weight of the main chain and the amount of the crosslinking agent added. It is possible to easily form a flexible light-transmissive layer with a micro rubber A-type hardness of 60 degrees or less on a rigid light-transmissive layer. Specific examples of silicone rubbers include SE9185, SE9186, SE9186L, SE9187L, etc., manufactured by Toray-Dow Corning Silicone Co., Ltd. A polyurethane rubber is prepared by reacting a carbinol-terminated polyether, such as polyethylene glycol, with an isocyanate crosslinking agent. By controlling the molecular weight of the polyether and the amount of the crosslinking agent, it is possible to relatively easily form a flexible light-transmissive layer with a micro rubber A-type hardness of 60 degrees or less on a rigid light-transmissive layer. A gel is defined as a polymer having a three-dimensional network structure which is insoluble in all liquids or a swollen body of such a polymer. Gels are classified into hydrogels which are swollen with water and organogels which are swollen with organic solvents or organic oligomers. Specific examples of hydrogels include synthetic polymer gels, such as three-dimensionally crosslinked poly(vinyl alcohol)s, three-dimensionally crosslinked poly(hydroxyethyl methacrylate), three-dimensionally crosslinked poly(acrylic acid), and three-dimensionally crosslinked sodium polyacrylate; and natural polymer gels, such as agar, gelatin, agarose, and carageenan. Specific examples of organogels include silicone gels in which silicone rubbers are swollen with silicone oligomers; and polyurethane gels in which polyurethane rubbers are swollen with ethylene glycol oligomers or the like. Among these gels, silicone gels are preferred because a flexible light-transmissive layer is relatively easily formed on a rigid light-transmissive layer.

Examples of materials for the rigid light-transmissive layer with a micro rubber A-type hardness of 80 degrees or more include transparent rigid polymers, such as rigid polyurethanes, poly(methyl methacrylate), polycarbonate, nylons, polyesters, transparent ABS, poly(vinyl chloride), poly(vinylidene fluoride), polyether sulfones, polystyrene, polyethylene, polypropylene, and poly(vinyl alcohol)s; and transparent inorganic materials, such as glass, rock crystal, transparent aluminum oxide, and indium titanium oxide.

The flexible light-transmissive layer and the rigid light-transmissive layer are preferably bonded to each other without an adhesion layer therebetween because light-transmitting properties are not impaired. The combination of the material for the flexible light-transmissive layer and the rigid light-transmissive layer is preferably determined in consideration of adhesive properties of the respective materials. For example, when glass is selected for the rigid light-transmissive layer, the flexible light-transmissive layer is preferably composed of a flexible polyurethane rubber, silicone rubber, silicone gel, polyurethane gel, or the like because of satisfactory adhesive properties. When a rigid polyurethane is selected for the rigid light-transmissive layer, the flexible light-transmissive layer is preferably composed of a flexible polyurethane rubber, polyurethane gel, or the like because of satisfactory adhesive properties. When a nylon is selected for the rigid light-transmissive layer, the flexible light-transmissive layer is preferably composed of a synthetic polymer gel, such as three-dimensionally crosslinked poly(vinyl alcohol)s and three-dimensionally crosslinked poly(hydroxyethyl methacrylate) because of satisfactory adhesive properties.

In another preferred example, the light-transmissive window member has a phase separation structure. Such a construction can be prepared using a transparent resin having a phase separation structure. As the transparent resin having a phase separation structure, a transparent resin composition having a heterogenous structure in which different polymers form multiple phases selected from multicomponent resin compositions prepared by blending at least two polymers or (co)polymers is preferred. A transparent resin composition prepared by melt-kneading at least two polymers or (co)polymers is more preferred. Above all, use of a transparent resin composition containing a rubber is preferable in view of the fact that occurrence of scratches due to the light-transmissive window member can be prevented.

In the light-transmissive window member of the present invention, a transparent resin composition having a heterogenous structure in which rubber and a transparent resin form separate phases is preferably used. Examples of the morphology thereof include a dispersed domain structure in which rubber particles form a dispersed phase in a transparent resin matrix, and a lamellar structure including a transparent resin layer and a rubber layer. Among them, a dispersed domain structure in which the continuous phase consists of a transparent resin matrix and the dispersed phase consists of rubber particles is preferable. Herein, the rubber particles correspond to a polymer or (co)polymer containing a rubber polymer as a principal component. The shape of the rubber particles is not particularly limited, but is preferably globular or oval. Although the size of the rubber particles is not particularly limited, the number-average particle size of the rubber particles is preferably 0.1 to 100 µm, more preferably 0.1 to 10 µm, and most preferably 0.2 to 5 µm. Additionally, the number-average particle size of the rubber particles is determined by digital image analysis of images observed with an optical microscope, transmission electron microscope, scanning electron microscope, phase-contrast microscope, or the like.

Preferably, the rubber used in the present invention has a glass transition temperature of 0°C or less. Specific examples thereof include diene rubbers, such as butadiene rubber, styrene-butadiene copolymers, acrylonitrile-butadiene copolymers, styrene-butadiene block copolymers, and butyl acrylate-butadiene copolymers; acrylic rubbers, such as poly(butyl acrylate); and other rubbers, such as natural rubber, grafted natural rubber, natural transpolyisoprene, chloroprene rubber, polyisoprene rubber, ethylene-propylene copolymers, ethylene-propylene-diene ternary copolymers, ethylene-acrylic copolymers, chlorosulfonated rubber, epichlorohydrin rubber, epichlorohydrin-ethylene oxide copolymers, polyether-urethane rubber, polyester-urethane rubber, nitrile rubber, butyl rubber, silicone rubber, and fluororubbers. Above all, diene rubbers, such as butadiene rubber and butadiene copolymers; and olefin rubbers, such as ethylene-propylene copolymers and ethylene-propylene-diene ternary copolymers, are preferable because of their excellent transparency.

The rubber particles are desirably dispersed uniformly in the transparent resin matrix which is the continuous phase. For that purpose, the rubber polymer is preferably grafted with a monomer constituting the transparent resin matrix, a polymer of the monomer, or a (co)polymer containing the monomer. Alternatively, the rubber polymer is preferably modified with a monomer containing at least one functional group, such as an epoxy group, isocyanate group, acid halide, carboxylic acid group, acid anhydride group, amide group, amino group, imino group, nitrile group, aldehyde group, hydroxyl group, or ester group.

The transparent resin composition usually contains a transparent resin besides the rubber. As such a transparent resin, either a thermoplastic resin or a thermosetting resin may be used. Above all, in view of moldability of the light-transmissive window member, thermoplastic resins are preferable. Specific examples of transparent thermoplastic resins include polyolefin resins; polystyrene resins; polyacrylic resins, such as poly(methyl methacrylate) and polyacrylonitrile; poly(vinyl halide) resins, such as poly(vinyl chloride); poly(vinylidene halide) resins, such as poly(vinylidene fluoride) and poly(vinylidene chloride); polytetrahalogenated ethylene resins, such as polytetrafluoroethylene; polyoxyalkylene resins, such as polyoxymethylene; polyamide resins; polyester resins, such as polyethylene terephthalate, polybutylene terephthalate, and polyethylene naphthalate; polycarbonate resins; poly(vinyl alkyl ether) resins, such as poly(vinyl methyl ether); poly(vinyl acetate) resins; polyurethane resins; polysulfone resins; poly(phenylene sulfide) resins; and polyarylate resins. Among them, in view of transparency, polystyrene resins, polyamide resins, polyester resins, and polyolefin resins are more preferable in the present invention.

The transparent window member of the present invention is preferably composed of a transparent resin composition having a heterogenous structure in which rubber particles are dispersed in the matrix of the transparent resin. Any transparent resin composition having a heterogenous structure may be used without limitations. Specific preferred examples include transparent resin compositions having a matrix of a transparent resin prepared by copolymerizing a styrene-based monomer with an unsaturated carboxylic acid alkyl ester, and a dispersed phase of rubber particles, such as transparent resin compositions containing rubber-reinforced styrene-based resins. Examples thereof include transparent high-impact polystyrene (HI-PS), transparent resin compositions containing acrylonitrile-butadiene-styrene copolymers (transparent ABS resins), transparent resin compositions containing acrylonitrile-acrylic rubber-styrene copolymers (transparent AAS resins), transparent resin compositions containing acrylonitrile-ethylene propylene rubber-styrene copolymers (transparent AES resins), transparent resin compositions containing methyl methacrylate-butadiene-styrene copolymers (transparent MBS resins), and transparent resin compositions containing acrylonitrile-chlorinated polyethylene-styrene copolymers (transparent ACS resins). Examples of transparent resin compositions having a polyolefin resin matrix and a dispersed phase of rubber particles include transparent resin compositions in which olefin rubbers are dispersed in polyethylene-containing resins, transparent resin compositions in which olefin rubbers are dispersed in polypropylene-containing resins, and transparent resin compositions in which olefin rubbers are dispersed in polypropylene-polyethylene copolymer-containing resins. Examples of transparent resin compositions having a polyamide resin matrix and a dispersed phase of rubber particles include transparent resin compositions in which maleic anhydride-modified olefin rubbers are dispersed in polyamide-containing resins. Examples of polyamides include nylon 6, nylon 8, nylon 11, nylon 12, nylon 66, nylon 68, and nylon 610. Examples of transparent resin compositions having a polyester resin matrix and a dispersed phase of rubber particles include transparent resin compositions in which polyolefin rubbers modified with methacrylates containing glycidyl groups are dispersed in polyester-containing resins. Examples of polyesters include poly(ethylene terephthalate) and poly(butylene terephthalate). Furthermore, transparent resin compositions in which acrylonitrile-butadiene copolymers are dispersed in poly(vinyl chloride)-based resins, and transparent resin compositions in which butyl acrylate-styrene copolymers or butyl acrylate-butadiene copolymers are dispersed in acrylic resins, such as poly(methyl methacrylate) may also be used. Among these transparent resin compositions, transparent resin compositions containing copolymers of rubber-reinforced styrene-based resins and unsaturated carboxylic acid alkyl esters are more preferably used because they can substantially prevent scratches from occurring and because of their excellent transparency.

Examples of a transparent resin composition (A) having a matrix of a transparent resin prepared by copolymerizing a styrene-based monomer with an unsaturated carboxylic acid alkyl ester and a dispersed phase of rubber particles include a structure in which a (co)polymer prepared from a styrene monomer, an unsaturated carboxylic acid alkyl ester monomer, a vinyl cyanide monomer, and another vinyl monomer copolymerizable with these monomers is grafted to a rubber polymer; and a structure in which a (co)polymer prepared from a styrene monomer, an unsaturated carboxylic acid alkyl ester monomer, a vinyl cyanide monomer, and another vinyl monomer copolymerizable with these monomers is not grafted to a rubber polymer. Specifically, preferred is a transparent thermoplastic resin including a graft copolymer (A) prepared by copolymerizing 20 to 90 parts by weight of a monomer mixture of an unsaturated carboxylic acid alkyl ester monomer (a), a styrene monomer (b), a vinyl cyanide monomer (c), and a vinyl monomer (d) copolymerizable with these monomers, under the presence of 10 to 80 parts by weight of a rubber polymer; and 0 to 90 parts by weight of a vinyl copolymer (B) composed of an unsaturated carboxylic acid alkyl ester monomer (a), a styrene monomer (b), a vinyl cyanide monomer (c), and a vinyl monomer (d) copolymerizable with these monomers, the rubber polymer content being 5 to 30 percent by weight, in view of the fact that scratches are prevented from occurring and high transparency is achieved.

As the rubber polymer (a1), a rubber polymer having a glass transition temperature of 0°C or less is suitable, and diene rubbers are preferably used. Specific examples include diene rubbers, such as polybutadiene, styrene-butadiene copolymers, acrylonitrile-butadiene copolymers, styrene-butadiene block copolymers, and butyl acrylate-butadiene copolymers; acrylic rubbers, such as poly(butyl acrylate); polyisoprene; and ethylene-propylene-diene ternary copolymers. Above all, polybutadiene or butadiene copolymers are particularly preferable.

The rubber particle size of the rubber polymer is not particularly limited. The weight-average particle size of the rubber particles is preferably 0.1 to 10 µm and more preferably 0.2 to 5 µm. Additionally, the weight-average particle size of rubber particles may be determined by a sodium alginate method described in "Rubber Age Vol. 88 p.484-490 (1960) by E. Schmidt, P. H. Biddison", in which using the phenomenon that the particle size of creaming polybutadiene particles varies depending on the sodium alginate concentration, the particle size at an accumulative fraction of 50% is determined based on the weight percentage of the creamed portion and the accumulative weight fraction of the sodium alginate concentration. Furthermore, the number-average particle size of the rubber particles may be determined by digital image analysis of images observed with an optical microscope, transmission electron microscope, scanning electron microscope, or phase-contrast microscope.

In the light-transmissive window member of the present invention, the transparent resin composition having the phase separation structure is disposed in the outermost region on the polishing surface. As long as the resin composition is disposed in the outermost region on the polishing surface, a single layer composed of the resin composition or a laminate including the resin composition and other resin or inorganic material may be used. A material having a compositional gradient may also be used.

In the present invention, the light-transmissive window member may be fabricated by a method in which a mixture of a transparent resin matrix and rubber particles, a composition obtained by melt-kneading a material prepared by polymerization of a transparent resin in the presence of rubber particles with a hot blender or extruder in advance, or a mixture prepared by mixing a transparent resin matrix and rubber particles with a mill is formed into a resin sheet using an injection molding machine, injection press, or extruder; and as necessary, the resin sheet is cut into a predetermined size.

Preferably, at least a part of the light-transmissive window member is disposed at a position higher than the surface of the polishing layer when the light-transmissive window member is not in contact with the substrate. When the region (the outermost surface, in particular) disposed higher than the surface of the polishing layer is composed of a flexible light-transmissive layer, a wide region of the transparent window member is brought into contact with the substrate, and the slurry is easily discharged from the contact area, thereby facilitating observation of the polished state. Since the surface of the light-transmissive window member abuts against and moves relatively to the surface to be polished, stress is easily concentrated at the boundary between the light-transmissive window member and the polishing layer. Consequently, if the end of the light-transmissive window member is placed higher than the surface of the polishing layer, the light-transmissive window member is susceptible to impact. Therefore, as shown in Figs. 2 to 6, by placing the center of the surface of the light-transmissive window member higher than the surface of the polishing layer, and by placing the edge of the light-transmissive window member lower than the surface of the polishing layer, the impact at the time of contact with the workpiece is substantially reduced, and the contact area with the substrate at the center though which light passes can be increased, thus enabling satisfactory polishing and satisfactory measurement.

The thickness of the light-transmissive window member is determined in consideration of the position at which the light-transmissive window member is fixed and the positional relationship with the surface of the polishing layer. Preferably, the flexible light-transmissive layer has a thickness of 0.1 mm or more in view of the fact that a sufficiently large area of the surface of the flexible light-transmissive layer can be brought into contact with the surface of the substrate and that scratches do not easily occur on the substrate. Preferably, the rigid light-transmissive layer has a thickness of 0.1 mm or more in view of the fact that the rigid light-transmissive layer can support the flexible light-transmissive layer so that a sufficiently large area of the surface of the flexible light-transmissive layer is brought into contact with the substrate. The size of the light-transmissive window member is determined depending on the apparatus in which, while a substrate, such as a wafer, is being polished, a laser beam or visible light is applied from the back side (platen side) of the polishing pad to a surface of the substrate to be polished so that the polished state is measured.

Preferably, a light-scattering layer or antireflection layer is provided on the back surface of the light-transmissive window member of the present invention so that measuring light from the back of the platen is not directly reflected in view of satisfactory measurement. In order to form the light-scattering layer, for example, a method in which the back surface of the light-transmissive window member is roughened by sandblasting, etching with an agent, or the like, or a method in which the back surface of the light-transmissive window member is coated with a solution containing silica gel with a particle size of about 1 to 30 µm may be employed. In order to form the antireflection layer, for example, a method may be employed in which a film having a lower refractive index than the back surface of the light-transmissive window member is formed by wet coating, dry coating, such as vacuum deposition, or the like so that the optical thickness is 1/4 or an odd multiple of optical wavelengths, thereby achieving the minimum reflectance, i.e., the maximum transmittance. Herein, the optical thickness is defined as a product of the refractive index of a film and the thickness of the film. The antireflection layer may be single-layered or multi-layered. In view of the refractive index, antireflective properties, and adhesive properties of the back surface of the light-transmissive window member, an optimum combination is determined. By forming an antireflection layer, the measurement can be carried out accurately, thus enabling highly accurate processing, which is desirable.

In order to fabricate the light-transmissive window member of the present invention, a method in which forming is carried out by pouring a thermosetting resin into a metal mold, or a method in which a thermoplastic resin is formed into a sheet with a predetermined thickness by extrusion may be used. In order to fabricate a light-transmissive window member including a flexible light-transmissive layer and a rigid light-transmissive layer, a method in which a rigid light-transmissive layer is formed using a transparent material with a micro rubber A-type hardness of 80 degrees or more, a viscous precursor for forming a flexible light-transmissive layer with a micro rubber A-type hardness of 60 degrees or less is applied to the rigid light-transmissive layer and allowed to react on the rigid light-transmissive layer to form the flexible light-transmissive layer, and then the resultant laminate is cut into a predetermined size; or a method in which a viscous precursor for forming a flexible light-transmissive layer is poured into a mold with a predetermined shape, and a sheet for forming a rigid light-transmissive layer is brought into contact with the viscous precursor at the opening of the mold to cause a reaction may be used.

The polishing apparatus of the present invention includes at least the polishing pad described above, means for supplying a slurry between the polishing pad and a workpiece, means for making the polishing pad abut on the substrate and relatively moving the polishing pad and the substrate to perform polishing, and means for optically measuring the polished state through the light-transmissive window member. The means other than the polishing pad may be constructed by combining conventionally known means. By using such an apparatus, applying a load between the polishing pad and the substrate while a slurry is interposed between the polishing pad and the substrate, and relatively moving the substrate and the polishing pad, the workpiece can be polished. By irradiating the workpiece with light, the polished state of the workpiece can be optically measured.

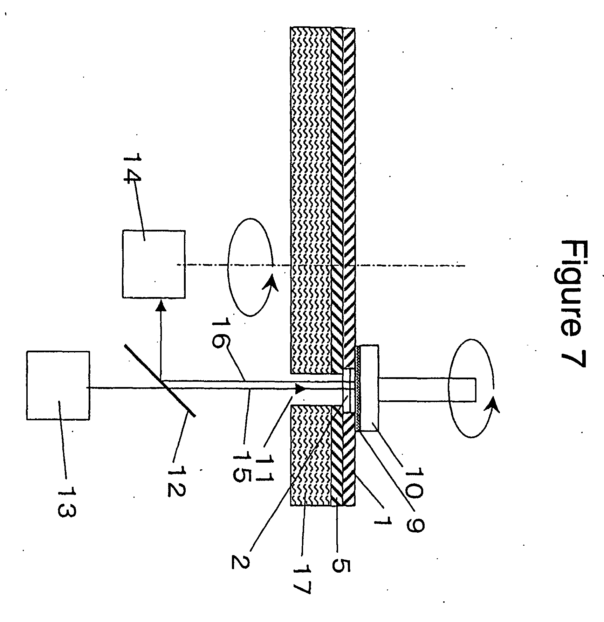

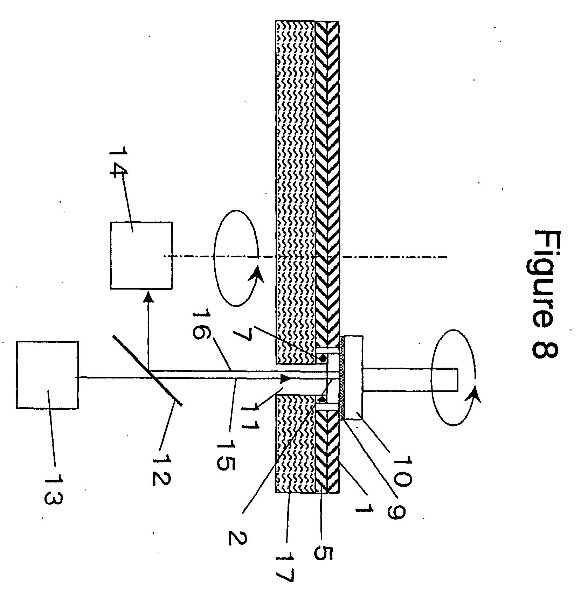

Specifically, Fig. 7 shows an example of a structure of an apparatus including a windowed polishing pad. A hole 11 is formed in a platen 17, and the polishing pad is disposed so that a light-transmissive window member 2 lies on the hole 11. The position of the hole 11 is determined so that a workpiece 9 held by a polishing head A can be observed while the platen 17 is rotated. A light source 13 is placed below the platen 17 and is fixed at a position which allows incident light 15 emitted from the light source 13 to pass through the hole 11 of the platen 17 and the window member 2 and hit the surface of the workpiece 9. Reflected light 16 from the surface of the workpiece 9 is guided to a photodetector 14 by a beam splitter 12. By analyzing the intensity waveform of the light detected by the photodetector 14, the polished state of the surface of the workpiece can be measured. Fig. 8 shows an example of a structure of an apparatus including a platen hole cover. A hole 11 is formed in a platen 17, and the platen hole 11 is covered with a platen hole cover including a light-transmissive window member and a highly deformable member. A polishing pad having an opening is attached to the platen 17 such that the platen hole cover is fitted in the opening in the polishing pad.

In accordance with the present invention, by using the windowed polishing pad or by using the platen hole cover and the polishing pad, and by using an abrasive material (which is preferably a slurry), e.g., a silica-based slurry, aluminum oxide-based slurry, or cerium oxide-based slurry, it is possible to locally planarize the insulating films and metal interconnections on semiconductor wafers, to perform global leveling, or to prevent dishing. Specific examples of the slurry include, but are not limited to, CAB-O-SPERSE SC-1 for CMP, CAB-O-SPERSE SC-112 for CMP, SEMI-SPERSE AM100 for CMP, SEMI-SPERSE AM100C for CMP, SEMI-SPERSE 12 for CMP, SEMI-SPERSE 25 for CMP, SEMI-SPERSE W2000 for CMP, and SEMI-SPERSE W-A400 for CMP manufactured by Cabot Microelectronics Corporation.

The windowed polishing pad or the combination of the platen hole cover and the polishing pad of the present invention is used, for example, for the surfaces of insulating layers or metal interconnections formed on semiconductor wafers. Examples of insulating layers include shallow trench isolation structures used for interlayer insulating films for metal interconnections and underlayer insulating films for metal interconnections, and used for isolation. Metal interconnections are composed of aluminum, tungsten, copper, or the like, and are structurally formed, for example, by damascene, dual damascene, or plug processes. When metal interconnections are composed of copper, barrier metals, such as silicon nitride, are also subjected to polishing. Although insulating films are currently predominantly composed of silicon oxide, insulating films composed of low-dielectric-constant materials are becoming to be used in view of delay time. In the polishing pad of the present invention, it is possible to measure the polished state satisfactorily while preventing scratches from occurring during polishing. The polishing pad can also be used for polishing magnetic heads, hard disks, sapphire, etc., besides semiconductor wafers.

In order to prevent hydroplaning, the surface of the windowed polishing pad or the polishing pad used together with the platen hole cover of the present invention may have any shape applicable to conventional polishing pads, e.g., a grooved, dimpled, spiral, or concentric shape.

In the windowed polishing pad or the combination of the platen hole cover and the polishing pad of the present invention, the surface of the polishing layer is usually subjected to dressing with a conditioner on which diamond abrasive grains are electro-deposited, before or during polishing. Either batch dressing performed before polishing or in situ dressing performed simultaneously with polishing may be used. During dressing, the flexible light-transmissive layer is also ground due to contact with the conditioner. The flexible light-transmissive layer is preferably composed of a material that has the same grinding properties as those of the polishing layer or that is less easily ground than the polishing layer because a part of the surface of the flexible light-transmissive layer can be always placed at a position higher than the surface of the polishing layer and brought into contact with the surface of the substrate.

It is an object of the present invention to provide a polishing pad which is used to form planar surfaces in glass, semiconductors, dielectric/metal composites, integrated circuits, etc.; a polishing apparatus including the polishing pad; and a method for fabricating a semiconductor device using the polishing apparatus, in which the number of scratches occurring on the surface of the substrate is small, and the polished state can be optically measured satisfactorily during polishing.

In the polishing method of the present invention, the upper area A", the load W", the amount of indentation strain S"1, and the amount of indentation strain S"2 can be defined as the same as the upper area A, the load W, the amount of indentation strain S1, and the amount of indentation strain S2 described with reference to the polishing pad, respectively. The polishing pads and light-transmissive window members suitable for use and the specific embodiments of use described above are also applicable to the polishing method.

### EXAMPLES

The present invention will be described in more detail based on the examples below. In the examples, individual properties were determined by the methods described below.
1. Indentation strain measuring device: Universal Testing Machine Model 1185 manufactured by Instron Corporation
   (1) Measurement method: Crosshead measurement
   (2) Indenter: An indenter which had an area corresponding to 90% of the upper area of a window member composed of aluminum and which had the same shape as that of the window member but was not in contact with a polishing layer was specially manufactured and mounted on the Universal Testing Machine.
   (3) Measurement temperature: 23°C
   (4) Testing rate: 0.1 mm/min
   (5) Data processing: Data processing system "Merlin" manufactured by Instron Corporation with a data acquisition interval of 100 msec
   (6) Amount of indentation strain at constant load: The difference between the strain generated when a constant weight (load) was applied and the strain generated when 10% of the constant weight (load) was applied was defined as the amount of indentation strain at the constant load.
   (7) Amount of indentation strain at constant pressure: The indentation strain at a constant pressure was calculated based on the strain generated when a constant load was applied and the contact area of the pressing jig, and the difference between the indentation strain at the constant pressure and the indentation strain generated when 10% of the constant pressure was applied was defined as the amount of indentation strain at the constant pressure.
2. Micro rubber A-type hardness: Measured with a rubber microhardness durometer "MD-1" manufactured by Kobunshi Keiki Co., Ltd. (address: Shimodachiuri Muromachi Nishiiri, Kamigyo-ku, Kyoto).

The construction of the rubber microhardness durometer "MD-1" is as follows:
2.1 Sensor
   (1) Loading system: Cantilever leaf spring
   (2) Spring load: 0 point/2.24 gf, 100 point/33.85 gf
   (3) Spring load error: ±0.32 gf
   (4) Indenter dimensions: Cylindrical with a diameter of 0.16 mm and a height of 0.5 mm
   (5) Displacement detection system: Strain gauge
   (6) Pressure foot dimensions: Outer diameter 4 mm, inner diameter 1.5 mm
2.2 Sensor driving unit
   (1) Driving system: Vertically driven by a stepping motor. Descending rate controlled by an air damper.
   (2) Vertical stroke: 12 mm
   (3) Descending rate: 10 to 30 mm/sec
   (4) Height adjustment range: 0 to 67 mm (distance between sample table and sensor pressure face)
2.3 Sample stand
   (1) Sample stand dimensions: Diameter 80 mm
   (2) Fine adjustment mechanism: Fine adjustment by XY table and micrometer head. Stroke: 15 mm for each of X axis and Y axis
   (3) Level adjustment mechanism: Main feet for level adjustment and round spirit level
3. Test wafer for scratch evaluation: 6-inch silicon wafer provided with oxide film (oxide film thickness: 1 µm)
4. Scratch evaluation: For the windowed polishing pad, using a polishing apparatus shown in Fig. 6, polishing was carried out for 2 minutes with a slurry SC-1 manufactured by Cabot Microelectronics Corporation being supplied at 200 cc/min while in situ dressing was carried out using a conditioner "CMP-M" manufactured by Asahi Diamond Industrial Co., Ltd. with a compression pressure of 0.04 MPa and at a conditioner rotational frequency of 25 rpm. The polishing conditions were as follows: platen diameter: 51 cm, platen rotational frequency: 60 rpm, polishing head rotational frequency: 60 rpm, and polishing pressure: 0.05 MPa. After the polished 6-inch silicon wafer was washed thoroughly, the number of scratches of 0.5 µm or more was measured with a wafer dust inspection system WM-3 manufactured by Topcon Corporation. For the platen hole cover, evaluation was performed using a polishing apparatus shown in Fig. 7 under the same conditions as those described above.
5. Method for checking how satisfactorily light-transmissive window member of windowed polishing pad or light-transmissive window member of platen hole cover enabled measurement of polished state: Using the wafer polishing apparatus shown in Fig. 6 or 7 and a laser beam of 532 nm, polishing was performed while in situ dressing was carried out using a conditioner "CMP-M" manufactured by Asahi Diamond Industrial Co., Ltd. with a compression pressure of 0.04 MPa and at a conditioner rotational frequency of 25 rpm. The polishing conditions were as follows: platen diameter: 51 cm, platen rotational frequency: 60 rpm, polishing head rotational frequency: 60 rpm, and polishing pressure: 0.05 MPa. When polishing was performed under the polishing conditions described above while supplying an aqueous solution of 90 ppm xanthan gum (polysaccharide), which was transparent and had substantially the same viscosity as that of the slurry, at 200 cc/min, reflected laser light was detected by the photodetector, and the intensity of reflected light was measured. The ratio of the intensity of reflected light to the intensity of incident light was defined as a blank reflectance. When polishing was performed under the polishing conditions described above while supplying a slurry SC-1 manufactured by Cabot Microelectronics Corporation at 200 cc/min, the reflected laser light was detected by the photodetector, and the intensity of reflected light was measured. The ratio of the intensity of reflected light to the intensity of incident light was defined as the reflectance in the presence of slurry. How satisfactorily the light-transmissive window member enabled the measurement of the polished state was indicated by how close the reflectance in the presence of slurry was to the blank reflectance. As the amount of slurry interposed between the surface of the window member and the surface of the substrate increased, the reduction in the reflectance increased.
6. Method for fabricating windowed polishing pad: An IC-1000 polishing layer manufactured by Rodel Inc. (1.25 mm thick, circular with a diameter of 51 cm) was subjected to a so-called X-Y grooving process (process for forming grooves in a grid shape) in which grooves were formed at a width of 2.0 mm, a depth of 0.5 mm, and a pitch of 45 mm. A rectangular opening of 19 × 57 mm was cut out at a predetermined position of the polishing layer. A rubber sheet (micro rubber A-type hardness: 50 degrees) with a predetermined thickness was attached to the polishing layer with a double-sided adhesive tape, and another double-sided adhesive tape was attached to the back surface of the rubber sheet. The rubber sheet at the opening of the polishing layer was cut out, the area of the cut-out portion of the rubber sheet being the same as that of the opening of the polishing layer. A double-sided adhesive tape was attached to the back surface of the rubber sheet, and a rectangular cutout of 13 × 50 mm was formed in the double-sided adhesive tape at the opening of the polishing layer/rubber sheet laminate. A light-transmissive window member which will be described below in each example was prepared in advance. A highly deformable member which will be described below in each example was prepared, the highly deformable member having an area of 18.5 × 56.5 mm and having a cutout of 13 × 50 mm in the center. The highly deformable member was inserted in the opening of the polishing layer/rubber sheet laminate and bonded to the fillet of the double-sided adhesive tape disposed at the back surface. The resultant polishing pad including the light-transmissive window member was fixed to a platen of the polishing apparatus shown in Fig. 7 such that the hole of the platen and the light-transmissive window member of the polishing pad corresponded to each other.
7. Method for fabricating platen hole cover and method for fabricating polishing pad having opening which is used together with platen hole cover: A light-transmissive window member which will be described below in each example was prepared in advance. A highly deformable member which will be described below in each example was prepared and adhesive layers were formed on both sides of the highly deformable member. A cutout of 13 × 50 mm was formed in the center of the highly deformable member having an area of 18.5 × 56.5 mm. The light-transmissive window member and the highly deformable member were combined to produce a platen hole cover. The platen hole cover was attached to the platen of the polishing apparatus shown in Fig. 7 so as to cover the entire platen hole. In order to fabricate the polishing pad having an opening which was used together with the platen hole cover, an IC-1000 polishing layer manufactured by Rodel Inc. (1.25 mm thick, circular with a diameter of 51 cm) was subjected to a so-called X-Y grooving process (process for forming grooves in a grid shape) in which grooves were formed at a width of 2.0 mm, a depth of 0.5 mm, and a pitch of 45 mm. A rubber sheet (micro rubber A-type hardness: 50 degrees) with a predetermined thickness was attached to the polishing layer with a double-sided adhesive tape, and another double-sided adhesive tape was attached to the back surface of the rubber sheet. An opening of 21 × 59 mm was formed in the polishing pad at the position corresponding to the platen hole. The polishing pad was attached to the platen such that the platen hole cover was placed in the center of the opening of the polishing pad.

### EXAMPLE 1

A transparent window member composed of transparent ABS was prepared by molding Toyolac 920 (transparent ABS resin) manufactured by Toray Industries, Inc. at a molding temperature of 60 to 80°C. The transparent window member had a thickness of 0.4 mm, a width of 18.5 mm, and a length of 56.5 mm. In the transparent window member, four corners and four edges of the upper surface were rounded with a radius of 0.4 mm. The micro rubber A-type hardness of the light-transmissive window member was 99 degrees. A polishing pad was fabricated by bonding an NBR rubber sheet with a thickness of 1 mm to a Rodel IC-1000. An opening of 19.5 × 57.5 mm was formed in the polishing pad at the position corresponding to the platen hole. A double-sided tape 442J manufactured by Sumitomo 3M Ltd. was attached to the rubber sheet side of the polishing pad having the opening, and a cutout of 13 × 50 mm was formed in the double-sided tape in the center of the opening. A highly deformable member composed of EPT sponge EPT#140 manufactured by Daiwabo Co., Ltd. with a thickness of 1.8 mm was prepared. A double-sided tape 442J manufactured by Sumitomo 3M Ltd. was attached to a surface of the highly deformable member with a size of 18.5 × 56.5 mm, and a cutout of 13 × 50 mm was formed in the center. The cushioning member and the transparent window member were laminated on each other, and then the laminate was bonded to the fillet of the double-sided tape at the back of the polishing pad having the opening. Thereby, a windowed polishing pad was prepared. The upper surface of the light-transmissive member of the windowed polishing pad protruded from the upper surface of the polishing layer in its periphery by about 0.2 mm. When a weight of 3,740 g was applied to the light-transmissive window member with a pressing jig having a contact area of 17 × 55 mm, the amount of indentation strain was 0.27 mm. When the same weight was applied to the polishing layer with the same pressing jig, the amount of indentation strain was 0.05 mm. Consequently, the amount of indentation strain at the light-transmissive window member was 5.4 times the amount of indentation strain at the polishing layer. A 6-inch silicon wafer provided with an oxide film was polished with the windowed polishing pad. The number of scratches was small at 17. The blank reflectance during polishing using the aqueous solution of xanthan gum was 60%. The reflectance during polishing using the slurry was 50%, and thus the decrease in the reflectance was small. As is clear from this result, the slurry was not substantially interposed between the light-transmissive window member and the wafer, and satisfactory observation was enabled.

### EXAMPLE 2

A transparent window member composed of transparent ABS was prepared as in Example 1. A highly deformable member composed of EPT sponge EPT#300 manufactured by Daiwabo Co., Ltd. with a thickness of 1.7 mm was prepared. Double-sided tapes 442J manufactured by Sumitomo 3M Ltd. were attached to both surfaces of the highly deformable member with a size of 18.5 × 56.5 mm, and a cutout of 13 × 50 mm was formed in the center. The transparent window member and the cushioning member were laminated on each other to form a platen hole cover. A polishing pad was fabricated by bonding an NBR rubber sheet with a thickness of 1 mm to a Rodel IC-1000 and attaching a double-sided tape 442J manufactured by Sumitomo 3M Ltd. to the back surface of the rubber. An opening of 21 × 59 mm was formed in the polishing pad at the position corresponding to the platen hole. When a weight of 3,000 g was applied to the light-transmissive window member of the platen hole cover with a pressing jig having a contact area of 17 × 55 mm, the amount of indentation strain was 0.15 mm. When the same weight was applied to the polishing layer of the polishing pad with the same pressing jig, the amount of indentation strain was 0.04 mm. Consequently, the amount of indentation strain at the light-transmissive window member was 3.75 times the amount of indentation strain at the polishing layer. The platen hole cover was attached to the platen, and the polishing pad was also attached to the platen such that the platen hole cover was fitted in the opening. The upper surface of the transparent window member of the platen hole cover protruded from the upper surface of the polishing layer of the polishing pad by about 0.1 mm.

A 6-inch silicon wafer provided with an oxide film was polished with the polishing pad and the platen hole cover. The number of scratches was small at 10. The blank reflectance during polishing using the aqueous solution of xanthan gum was 55%. The reflectance during polishing using the slurry was 48%, and thus the decrease in the reflectance was small. As is clear from this result, the slurry was not substantially interposed between the light-transmissive window member of the platen hole cover and the wafer, and satisfactory observation was enabled.

### EXAMPLE 3

By polymerization of MMA, a PMMA sheet with a thickness of 0.3 mm was formed, and the PMMA sheet was coated with one-part silicone SE9185 manufactured by Toray-Dow Corning Silicone Co., Ltd. at a thickness of 0.3 mm. Thereby, a transparent window member with a thickness of 0.6 mm and a size of 18.5 a 56.5 mm was fabricated. The silicone rubber layer had a micro rubber A-type hardness of 50 degrees, and the PMMA layer had a micro rubber A-type hardness of 99 degrees. A polishing pad was fabricated by bonding a foamed polyurethane sheet with a thickness of 1 mm and a density of 0.1 to a Rodel IC-1000. An opening of 19.5 × 57.5 mm was formed in the polishing pad at the position corresponding to the platen hole. A double-sided tape 442J manufactured by Sumitomo 3M Ltd. was attached to the foamed polyurethane side of the polishing pad having the opening, and a cutout of 13 × 50 mm was formed in the double-sided tape in the center of the opening. A highly deformable member composed of EPT sponge #140 manufactured by Daiwabo Co., Ltd. with a thickness of 1.6 mm was prepared. A double-sided tape 442J manufactured by Sumitomo 3M Ltd. was attached to a surface of the highly deformable member with a size of 18.5 × 56.5 mm, and a cutout of 13 × 50 mm was formed in the center. The cushioning member and the transparent window member were laminated on each other, and the laminate was bonded to the fillet of the double-sided adhesive tape disposed at the back surface of the polishing pad having the opening. Thereby, a windowed polishing pad was produced. The upper surface of the light-transmissive window member of the windowed polishing pad protruded from the upper surface of the polishing layer in its periphery by about 0.1 mm. When a weight of 1,500 g was applied to the light-transmissive window member with a pressing jig having a contact area of 17 × 55 mm, the amount of indentation strain was 0.11 mm. When the same weight was applied to the polishing layer with the same pressing jig, the amount of indentation strain was 0.05 mm. Consequently, the amount of indentation strain at the light-transmissive window member was 2.2 times the amount of indentation strain at the polishing layer. A 6-inch silicon wafer provided with an oxide film was polished with the windowed polishing pad. The number of scratches was small at 15. The blank reflectance during polishing using the aqueous solution of xanthan gum was 45%. The reflectance during polishing using the slurry was 38%, and thus the decrease in the reflectance was small. As is clear from this result, the slurry was not substantially interposed between the light-transmissive window member and the wafer, and satisfactory observation was enabled.

### EXAMPLE 4

A light-transmissive window member similar to that in Example 3 was fabricated. A highly deformable member composed of EPT sponge EPT#140 manufactured by Daiwabo Co., Ltd. with a thickness of 1.7 mm was prepared. Double-sided tapes 442J manufactured by Sumitomo 3M Ltd. were attached to both surfaces of the highly deformable member with a size of 18.5 × 56.5 mm, and a cutout of 13 × 50 mm was formed in the center. The transparent window member and the cushioning member were laminated on each other to form a platen hole cover. An opening of 21 × 59 mm was formed in a Rodel IC-1000/Suba400 laminated polishing pad at the position corresponding to the platen hole. When a weight of 2,000 g was applied to the light-transmissive window member of the platen hole cover with a pressing jig having a contact of 17 × 55 mm, the amount of indentation strain was 0.14 mm. When the same weight was applied to the polishing layer of the polishing pad with the same pressing jig, the amount of indentation strain was 0.02 mm. Consequently, the amount of indentation strain at the light-transmissive window member was 7 times the amount of indentation strain at the polishing layer. The platen hole cover was attached to the platen, and the polishing pad was also attached to the platen such that the platen hole cover was fitted in the opening. The upper surface of the transparent window member of the platen hole cover protruded from the upper surface of the polishing layer of the polishing pad by about 0.2 mm. A 6-inch silicon wafer provided with an oxide film was polished with the polishing pad and the platen hole cover. The number of scratches was small at 17. The blank reflectance during polishing using the aqueous solution of xanthan gum was 55%. The reflectance during polishing using the slurry was 48%, and thus the decrease in the reflectance was small. As is clear from this result, the slurry was not substantially interposed between the light-transmissive window member and the wafer, and satisfactory observation was enabled.

### EXAMPLE 5

A rigid polyurethane sheet with a thickness of 0.25 mm was formed by mixing 300 g of Uniroyal Adiprene L-325, i.e., a polyether-based urethane polymer, and 76 g of 4,4'-methylene-bis(2-chloroaniline) and pouring the mixture into a mold. The rigid polyurethane sheet had a micro rubber A-type hardness of 95 degrees. A light-transmissive window member was fabricated by cutting the rigid polyurethane sheet into a size of 18.5. × 56.5 mm. Using a polishing pad prepared by bonding a rubber sheet with a thickness of 1 mm to an IC-1000, the light-transmissive window member, and acrylic foam adhesive tape Y-4620 manufactured by Sumitomo 3M Ltd. as a highly deformable member, a polishing pad provided with the light-transmissive window member was fabricated. When a pressure of 400 g was applied to the light-transmissive window member of the polishing pad, the amount of indentation strain was 0.21 mm. The amount of indentation strain at the polishing layer was 0.06 mm. Consequently, the amount of indentation strain at the light-transmissive window member was 3.5 times the amount of indentation strain at the polishing layer. A 6-inch silicon wafer provided with an oxide film was polished with the polishing pad provided with the light-transmissive window member. The number of scratches was small at 20. The blank reflectance during polishing using the aqueous solution of xanthan gum was 50%. The reflectance during polishing using the slurry was 40%, and thus the decrease in the reflectance was small. As is clear from this result, the slurry was not substantially interposed between the light-transmissive window member and the wafer, and satisfactory observation was enabled.

### EXAMPLE 6

A glass sheet with a thickness of 0.5 mm was prepared. A single-layer antireflection film was formed by vapor deposition of magnesium fluoride on the back surface of the glass sheet. The glass sheet had a micro rubber A-type hardness of 100 degrees. The glass sheet was coated with one-part silicone SE9185 manufactured by Toray-Dow Corning Silicone Co., Ltd. at a thickness of 0.3 mm, and left to stand at 60°C for 1 hour. The laminate was cut into a size of 18.5 × 56.5 mm with a diamond cutter, and the silicone rubber was cut with a cutter knife to form a light-transmissive window member with a shape shown in Fig. 7. The flexible light-transmissive layer had a micro rubber A-type hardness of 30 degrees. Using a polishing pad prepared by bonding a rubber sheet with a thickness of 1.5 mm to an IC-1000, the light-transmissive window member, and an acrylic foam adhesive tape Y-4620 manufactured by Sumitomo 3M Ltd. as a highly deformable member, a polishing pad provided with the light-transmissive window member was fabricated. The amount of indentation strain at the light-transmissive window member of the polishing pad was 0.21 mm under a pressure of 400 g. The amount of indentation strain at the polishing layer was 0.06 mm. Consequently, the amount of indentation strain at the light-transmissive window member was 3.5 times the amount of indentation strain at the polishing layer. A polishing pad provided with a light-transmissive window member was fabricated using the light-transmissive window member, and a 6-inch silicon wafer provided with an oxide film was polished with the polishing pad provided with the light-transmissive window member. The number of scratches was small at 5. The blank reflectance during polishing using the aqueous solution of xanthan gum was 60%. The reflectance during polishing using the slurry was 48%, and thus the decrease in the reflectance was small. As is clear from this result, the slurry was not substantially interposed between the light-transmissive window member and the wafer, and satisfactory observation was enabled.

### COMPARATIVE EXAMPLE 1

A rigid polyurethane sheet with a thickness of 1.25 mm was formed by mixing 300 g of Uniroyal Adiprene L-325, i.e., a polyether-based urethane polymer, and 76 g of 4,4'-methylene-bis(2-chloroaniline) and pouring the mixture into a mold. The rigid polyurethane sheet had a micro rubber A-type hardness of 95 degrees. A light-transmissive window member was formed by cutting the rigid polyurethane sheet into a size of 18.5 × 56.5 mm. An opening of 19 × 57 mm was formed in an IC-1000 and a rubber sheet with a thickness of 1 mm was bonded to the IC-1000 with a double-sided tape. A cutout of 13 × 50 mm was formed in the rubber sheet at the position corresponding to the opening. The light-transmissive window member was inserted into the opening and bonded to the fillet of the rubber sheet. A polishing pad provided with the light-transmissive window member was thereby fabricated. The amount of indentation strain at the transmissive window member of the polishing pad was 0.035 mm under a pressure of 400 g. The amount of indentation strain at the polishing layer was 0.07 mm. Consequently, the amount of indentation strain at the light-transmissive window member was smaller than the amount of indentation strain at the polishing layer. A 6-inch silicon wafer provided with an oxide film was polished with the polishing pad provided with the light-transmissive window member. The number of scratches was large at 110. The blank reflectance during polishing using the aqueous solution of xanthan gum was 55%. The reflectance during polishing using the slurry was 15%, and thus the decrease in the reflectance was large. As is clear from this result, a large amount of the slurry was interposed between the light-transmissive window member and the wafer, and satisfactory observation was not performed.

### COMPARATIVE EXAMPLE 2

A light-transmissive window member composed of transparent ABS was formed at a thickness of 1.3 mm and a size of 18.5 × 56.5 mm. The light-transmissive window member had a micro rubber A-type hardness of 99 degrees. An opening of 19.5 × 57.5 mm was formed in a Rodel IC-1000 at the position corresponding to the platen hole. Double-sided tapes 442J manufactured by Sumitomo 3M Ltd. were attached to both surfaces of an NBR rubber sheet with a thickness of 1 mm. The NBR rubber sheet was bonded to the IC-1000 having the opening. A cutout of 13 × 50 mm was formed in the NBR rubber in the center of the opening. The light-transmissive window member was fitted in the opening and bonded to the rubber and the fillet of the double-sided tape. A windowed polishing pad was thereby fabricated. The upper surface of the light-transmissive window member of the windowed polishing pad protruded from the polishing layer in its periphery by about 0.1 mm. When a weight of 3,000 g was applied to the light-transmissive window member with a pressing jig having a contact area of 17 × 55 mm, the amount of indentation strain was 0.05 mm. When the same weight was applied to the polishing layer with the same pressing jig, the amount of indentation strain was 0.04 mm. Consequently, the amount of indentation strain at the light-transmissive window member was 1.25 times the amount of indentation strain at the polishing layer. A 6-inch silicon wafer provided with an oxide film was polished with the windowed polishing pad. The number of scratches was significantly large at 300. The blank reflectance during polishing using the aqueous solution of xanthan gum was 60%. The reflectance during polishing using the slurry was 50%, and thus the decrease in the reflectance was small. As is clear from this result, the slurry was not substantially interposed between the light-transmissive window member and the wafer, and satisfactory observation was enabled.

### COMPARATIVE EXAMPLE 3

A transparent window member composed of transparent ABS was prepared as in Example 1. An NBR rubber sheet with a thickness of 1.9 mm was prepared. Double-sided tapes 442J manufactured by Sumitomo 3M Ltd. were attached to both surfaces of the NBR rubber sheet with a size of 18.5 × 56.5 mm, and a cutout of 13 × 50 mm was formed in the center. The transparent window member and the cushioning member were laminated on each other to form a platen hole cover. A polishing pad was fabricated by bonding an NBR rubber sheet with a thickness of 1 mm to a Rodel IC-1000 and attaching a double-sided tape 442J manufactured by Sumitomo 3M Ltd. to the back surface of the rubber. An opening of 21 × 59 mm was formed in the polishing pad at the position corresponding to the platen hole. When a weight of 3,000 g was applied to the light-transmissive window member of the platen hole cover with a pressing jig having a contact area of 17 × 55 mm, the amount of indentation strain was 0.05 mm. When the same weight was applied to the polishing layer of the polishing pad with the same pressing jig, the amount of indentation strain was 0.04 mm. Consequently, the amount of indentation strain at the light-transmissive window member was 1.25 times the amount of indentation strain at the polishing layer. The platen hole cover was attached to the platen, and the polishing pad was also attached to the platen such that the platen hole cover was fitted in the opening. The upper surface of the transparent window member of the platen hole cover protruded from the upper surface of the polishing layer of the polishing pad by about 0.1 mm.

A 6-inch silicon wafer provided with an oxide film was polished with the polishing pad and the platen hole cover. The number of scratches was large at 260. The blank reflectance during polishing using the aqueous solution of xanthan gum was 55%. The reflectance during polishing using the slurry was 48%, and thus the decrease in the reflectance was small. As is clear from this result, the slurry was not substantially interposed between the light-transmissive window member of the platen hole cover and the wafer, and satisfactory observation was enabled.

## Claims

1. A polishing pad comprising a polishing layer and a light-transmissive window member disposed in an opening formed in a part of the polishing layer, wherein the amount of indentation strain (S1) measured under a load W applied to the light-transmissive window member having an upper area A is larger than the amount of indentation strain (S2) measured under a load W applied to a region having the area A at any position on the upper surface of the polishing layer.

2. A polishing pad according to Claim 1, wherein S1/S2 ≥ 1.5.

3. A polishing pad according to either Claim 1 or 2, wherein the light-transmissive window member is supported by a highly deformable member.

4. A polishing pad according to Claim 3, wherein the compression modulus of the highly deformable member is 0.001 to 0.8 MPa.

5. A polishing pad according to any one of Claims 1 to 4, wherein at least a part of the light-transmissive window member is disposed at a position higher than the surface of the polishing layer.

6. A polishing pad according to any one of Claims 1 to 5, wherein the light-transmissive window member has a region having a micro rubber A-type hardness of 60 degrees or less and a region having a rubber microhardness of 80 degrees or more.

7. A polishing pad according to any one of Claims 1 to 6, wherein the light-transmissive window member has a phase separation structure.

8. A polishing apparatus comprising at least the polishing pad according to any one of Claims 1 to 7, means for supplying an abrasive material between the polishing pad and a workpiece, means for making the polishing pad abut on the workpiece and relatively moving the polishing pad and the workpiece to perform polishing, and means for optically measuring the polished state of the workpiece through the light-transmissive window member.

9. A method for fabricating a semiconductor device comprising the step of polishing a surface of the semiconductor substrate using the polishing apparatus according to Claim 8.

10. A platen hole cover comprising a light-transmissive window member, the platen hole cover being used together with a polishing pad having an opening and fixed on a hole of a platen in a polishing apparatus in which the polished state can be optically measured, wherein the amount of indentation strain (S'1) measured under a load W' applied to the upper surface of the light-transmissive window member having an upper area A' is larger than the amount of indentation strain (S'2) measured under a load W' applied to a region having the area A' at any position on the upper surface of a polishing layer of the polishing pad used together.

11. A platen hole cover according to Claim 10, wherein S'1 ≥ S'2.

12. A platen hole cover according to either Claim 10 or 11, wherein the light-transmissive window member is supported by a highly deformable member.

13. A platen hole cover according to Claim 12, wherein the compression modulus of the highly deformable member is 0.001 to 0.8 MPa.

14. A platen hole cover according to any one of Claims 10 to 13, wherein at least a part of the upper surface of the light-transmissive window member is disposed at a position higher than the surface of the polishing layer of the polishing pad before the start of polishing.

15. A platen hole cover according to any one of Claims 10 to 14, wherein the light-transmissive window member has a region having a micro rubber A-type hardness of 60 degrees or less and a region having a micro rubber A-type hardness of 80 degrees or more.

16. A platen hole cover according to any one of Claims 10 to 15, wherein the light-transmissive window member has a phase separation structure.

17. A polishing apparatus comprising:
the platen hole cover according to any one of Claims 10 to 16;
a polishing pad having an opening engageable with the platen hole cover;
means for supplying an abrasive material between the polishing pad and a surface to be polished;
means for making the polishing pad abut on the surface to be polished and relatively moving the polishing pad and the surface to be polished to perform polishing; and
means for optically measuring the polished state of a workpiece through the light-transmissive window member.

18. A method for fabricating a semiconductor device comprising the step of polishing a surface of a semiconductor substrate using the polishing apparatus according to Claim 17.

19. A method for polishing a workpiece comprising the steps of:
disposing a polishing pad comprising a polishing layer, a light-transmissive window member which constitutes a part of the polishing pad or which is independent of the polishing pad on a platen so that the polishing pad and the light-transmissive window member can abut against the workpiece;
setting the amount of indentation strain (S"1) measured under a load W" applied to the upper surface of the light-transmissive window member having an upper area A" to be larger than the amount of indentation strain (S"2) measured under a load W" applied to a region having the area A" at any position on the surface of the polishing layer of the polishing pad; and
supplying an abrasive material between the polishing pad and the workpiece while the polished state of the workpiece is being optically measured through the light-transmissive window member.
